(19) Europäisches Patentamt
European Patent Office
Office européen des brevets

(11) **EP 4 576 586 B1**

(12) **EUROPEAN PATENT SPECIFICATION**

(45) Date of publication and mention
of the grant of the patent:
**24.12.2025  Bulletin 2025/52**

(21) Application number: **24165862.4**

(22) Date of filing: **25.03.2024**

(51) International Patent Classification (IPC):
***H03M 13/15*** *(2006.01)*      ***H03M 13/29*** *(2006.01)*
*H03M 13/13* *(2006.01)*

(52) Cooperative Patent Classification (CPC):
**H03M 13/1515; H03M 13/1575; H03M 13/158;**
**H03M 13/2906; H03M 13/2948;** H03M 13/13

(54) **HARDWARE EFFICIENT SYNDROME CALCULATION FOR OUT-OF-ORDER ARRIVING REED-SOLOMON CODEWORD SYMBOLS**

HARDWAREEFFIZIENTE SYNDROMBERECHNUNG FÜR UNGEORDNET ANKOMMENDE REED-SOLOMON KODEWORTSYMBOLEN

CALCUL DU SYNDROME D'EFFICACITÉ MATÉRIELLE POUR LES SYMBOLES DE MOTS DE CODE REED-SOLOMON HORS ORDRE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority:  **19.12.2023  US 202318389602**

(43) Date of publication of application:
**25.06.2025  Bulletin 2025/26**

(73) Proprietor: **Samsung Electronics Co., Ltd.**
**Suwon-si, Gyeonggi-do 16677 (KR)**

(72) Inventors:
• **BERMAN, Amit**
**6492103 Tel-Aviv (IL)**
• **SHAPIRO, Dikla**
**6492103 Tel-Aviv (IL)**

(74) Representative: **Kuhnen & Wacker**
**Patent- und Rechtsanwaltsbüro PartG mbB**
**Prinz-Ludwig-Straße 40A**
**85354 Freising (DE)**

(56) References cited:
**US-A1- 2018 152 203      US-B1- 11 689 216**

• **CHO JUNHO ET AL: "Area-Efficient Parallel Syndrome Generators for Linear Block Codes", JOURNAL OF SIGNAL PROCESSING SYSTEMS, SPRINGER, US, vol. 77, no. 3, 20 July 2013 (2013-07-20), pages 281 - 287, XP035403920, ISSN: 1939-8018, [retrieved on 20130720], DOI: 10.1007/S11265-013-0810-Y**

## Description

## TECHNICAL FIELD:

Embodiments of the present disclosure are directed to syndrome calculations in generalized concatenated error correction codes.

## DISCUSSION OF THE RELATED ART:

US 2018 / 0 152 203 A1 discloses an error correction circuit that includes a syndrome calculator suitable for generating syndromes from an "n"-bit codeword for a single unit of time, an error location polynomial calculator suitable for generating error location polynomial coefficients based on the syndromes provided for the single unit of time, an error location calculator suitable for calculating error locations based on the error location polynomial coefficients for the single unit of time, and an error corrector suitable for correcting errors of the codeword based on the error locations for the single unit of time. The error correction circuit operates in a pipelining manner.

The publication of CHO JUNHO ET AL: "Area-Efficient Parallel Syndrome Generators for Linear Block Codes", Journal of Signal Processing Systems, Springer, vol. 77, no. 3, 20 July 2023, XP 35403920A, does also constitute prior art.

US 11 689 216 B1 discloses a device for decoding a generalized concatenated code, GCC, codeword includes: a buffer; and at least one processor configured to: obtain the GCC codeword, calculate a plurality of inner syndromes based on a plurality of frames; calculate a plurality of sets of delta syndromes based on the frames; determine a plurality of outer syndromes based on the sets of delta syndromes; store the inner syndromes and the outer syndromes in a buffer; perform inner decoding on the frames based on the inner syndromes stored in the buffer; update at least one outer syndrome stored in the buffer based on a result of the inner decoding; perform outer decoding on the frames based on the updated at least one outer syndrome; and obtain decoded information bits corresponding to the GCC codeword based on a result of the inner decoding and the result of the outer decoding.

Reed-Solomon (RS) codes are a group of error-correcting codes used for correcting errors in data transmitted over unreliable or noisy communication channels. The transmitted message $(c_0, ..., c_i, ..., c_{n-1})$ can be viewed as the coefficients of a polynomial:

$$s(x) = \sum_{i=0}^{n-1} c_i x^i.$$

The transmitted polynomial is corrupted in transit by an error polynomial $e(x)$ to produce the received polynomial $r(x)$"

$$r(x) = s(x) + e(x),$$

where $e(x) = \sum_{i=1}^{n-1} e_i x^i$. Coefficient $e_i$ will be zero if there is no error at that power of $x$ and nonzero if there is an error. The decoder starts by evaluating the polynomial as received at points $\alpha^1 ... \alpha^{n-k}$, where the $\alpha$'s are primitive elements of the RS generator polynomial. These results are referred to as the syndromes $S_j$.

A RS syndrome calculation can be described as follows:

$$S_m = \sum \alpha^{jm} \times F_j,$$

Where $m$ refers to the $m$th syndrome, where $m = 1, ..., D$, and $F_j$ is the j-th symbol of the RS codeword, which is a delta-frozen symbol of the jth frame in a generalized concatenated (GCC) code, where a frame (or row) is a codeword of the inner code in a GCC, which, in embodiments of the disclosure, is a polar or BCH code. In an SPolar code, the inner code is a Polar code, and the outer code is an RS code. A delta-frozen symbol refers to the additional parity of a polar frame.

## SUMMARY

The invention is set out in the appended claims.

Embodiments of the disclosure can calculate D Syndromes for each Reed-Solomon Decoding.

Embodiments of the disclosure can receive the symbols in any order, and calculate the addition for all syndromes.

Embodiments of the disclosure can maintain a Reed-Solomon syndrome (RSS) for RS decoding between activations.

According to an embodiment of the disclosure, there is provided a hardware circuit for calculating syndromes in Reed-Solomon (RS) error correction codes. The hardware circuit comprises a plurality of $p$ multiplexors, wherein $p$ is a positive integer, wherein each multiplexor receives $\alpha^{\wedge}i$ powers that are selected by $j$, wherein $\alpha$ is a primitive point of a RS generator polynomial and $j$ is an index of an RS symbol, wherein $i$ and $j$ are positive integers, wherein $1 \leq i \leq p$, and outputs $\alpha^{\wedge}(i \times j)$; and a plurality of $p$ first multipliers, wherein each first multiplier is associated with a multiplexor and receives $\alpha^{\wedge}(i \times j)$ from the associated multiplexor, multiplies the $\alpha^{\wedge}(i \times j)$ by a $j$th RS-word symbol $R_j$ and outputs $R_f \times \alpha^{\wedge}(i \times j)$. The hardware circuit calculates and outputs $p$ products of the form $R_f \times \alpha^{\wedge}(i \times j)$, wherein $1 \leq i \leq p$.

According to the embodiment of the disclosure, the hardware circuit comprises a plurality of $p$ second multipliers, where each second multiplier is associated with a multiplexor, and receives $\alpha^{\wedge}(i \times j)$ from the associated multiplexor and $R_j \times a^{\wedge}(p \times j)$ from a pth first multiplier of the plurality of first multipliers, and multiplies

the $R_j \times \alpha^\wedge(p \times j)$ by the $\alpha^\wedge(i \times j)$. The hardware circuit further calculates and outputs $p$ products of the form $R_j \times \alpha^\wedge((i+p) \times j)$, wherein $1 \le i \le$ p.

According to a further embodiment of the disclosure, for $n$ syndromes, where $n = 2 \times p \times m$, where $n$ and $m$ are positive integers, the circuit repeats calculating and outputting a next $2 \times p$ products $m$ times, wherein the $j$th RS-word symbol $R_j$ for a $k$th iteration is replaced by $R_j \times \alpha^\wedge(2pj)$ from a (k-1)th iteration, wherein $1 \le k \le m$.

According to a further embodiment of the disclosure, the hardware circuit comprises a plurality of $p$ second multipliers, where each second multiplier receives the product $R_j \times \alpha^\wedge(i \times j)$, wherein $1 \le i \le p$, multiplies the product $R_j \times \alpha^\wedge(i \times j)$ by $\alpha^\wedge(pj)$ and outputs a result $R_j \times \alpha^\wedge((i+p) \times j)$.

According to a further embodiment of the disclosure, for $n$ syndromes, where $n = 2 \times p \times m$, where $n$ and $m$ are positive integers, the circuit repeats calculating and outputting a next $p$ products $m$ times, wherein the $j$th RS-word symbol $R_j$ for a $k$th iteration is replaced by $R_j \times \alpha^\wedge(2pj)$ from a (k-1)th iteration, wherein $1 \le k \le m$, and multiplies each of the $p$ products by $\alpha^\wedge(pj)$ and outputs a result thereof.

According to a further embodiment of the disclosure, the hardware circuit comprises a first GF-square hardware unit connected to an output of each multiplexor, where the GF-square hardware unit squares the $\alpha^\wedge(i \times j)$ received from the connected multiplexor; a first register, a second register, and a third register, where the first register stores a result $\alpha^\wedge2(i \times j)$ received from the first GF-square hardware unit, the second register stores a result $R_j \times \alpha^\wedge(i \times j)$ received from a first multiplier associated with the connected multiplexor, and the third register stores the $j$th RS-word symbol $R_j$; a first iterative multiplier that calculates a first product of the result stored in the first register and the result $R_j \times \alpha^\wedge(i \times j)$ stored in the second register, and outputs the first product; and a second iterative multiplier that calculates a second product of the result stored in the first register and the $j$th RS-word symbol $R_j$ and outputs the second product. The result $\alpha^\wedge2(i \times j)$ stored in the first register is kept stable for all subsequent calculations of the syndrome.

According to a further embodiment of the disclosure, the hardware circuit comprises a first pipeline multiplexor disposed between the first multiplier of each multiplexor and the second register; and a second pipeline multiplexor disposed between an input line for the $j$th RS-word symbol $R_j$ and the third register. The first pipeline multiplexor receives the first product from the first iterative multiplier, the second pipeline multiplexor receives the second product from the second iterative multiplier, and each of the first and second pipeline multiplexor respectively selects the first product and the second product for a new calculation of $R_j \times \alpha^\wedge(i \times j)$ and $R_j \times \alpha^\wedge((i+p) \times j)$ while a previous calculation of $R_j \times \alpha^\wedge(i \times j)$ and $R_j \times \alpha^\wedge((i+p) \times j)$ is still in progress.

According to a further embodiment of the disclosure, the hardware circuit comprises a second GF-square hardware unit connected to an output of each first GF-square hardware unit, where the GF-square hardware unit squares the $\alpha^\wedge(2j)$ received from the connected first GF-square hardware unit; a third iterative multiplier that calculates a third product of a result $\alpha^\wedge(4j)$ received from the second GF-square hardware unit and the result $R_j \times \alpha^\wedge(i \times j)$ stored in the second register, and outputs the third product, and a fourth iterative multiplier that calculates a fourth product of the result $\alpha^\wedge(4j)$ received from the second GF-square hardware unit and the $j$th RS-word symbol $R_j$ stored in the third register, and outputs the second product.

According to a further embodiment of the disclosure, the hardware circuit comprises a fourth register disposed between the second GF-square hardware unit and the third iterative multiplier, and that stores the result $\alpha^\wedge(4j)$ received from the second GF-square hardware unit.

## BRIEF DESCRIPTION OF THE DRAWINGS

FIGS. 1A and 1B illustrate hardware that calculates the i-th syndrome using Horner's Rule, for all symbols, according to embodiments of the disclosure.

FIG. 2 illustrates hardware that calculates and accumulates the contribution of each symbol, $r_j$, to the syndrome, according to embodiments of the disclosure.

FIGS. 3A, 3B, 3C, 3D, and 3E illustrate decoding of generalized concatenated error correction code words, according to embodiments of the disclosure.

FIG. 4 illustrates an exemplary hardware for a specific syndrome $i$, according to embodiments of the disclosure.

FIG. 5 illustrates hardware for an iterative calculation, according to embodiments of the disclosure.

FIGS. 6A and 6B illustrate hardware that, from the 2nd iteration on, samples $\alpha^{ij}$ in registers or keeps $\alpha^{ij}$ stable, and implements the 2nd 2 sets (or more) with only 2 multipliers, according to embodiments of the disclosure.

## DETAILED DESCRIPTION

Hereinafter, embodiments of the present disclosure will be described with reference to accompanying drawings.

Two options for calculating syndromes are as follows.

**Option 1: Horner Rule**

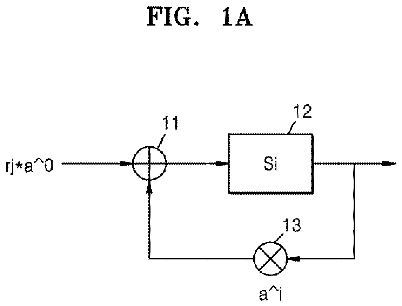

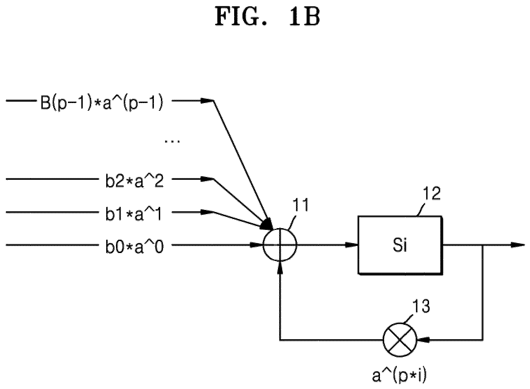

The Horner rule is very efficient when symbols are received in order. For each syndrome $S_i$, ($i = 0, ..., D-1$), the syndrome value is the evaluation of the input polynomial in $\alpha^i$. The input symbols are referred to as polynomial coefficients, received from the highest degree. The syndrome calculation for all sequential symbols (RS word) can be implemented by Horner rule, optionally with parallelism. When the codeword symbols are received in order, the accumulative result is multiplied by $\alpha^i$, and the new symbol is added each time. When all symbols have been received, the syndrome is ready. FIGS. 1A and 1B illustrate hardware that calculates the i-th syndrome, for all symbols. FIG. 1A shows hardware that calculates the i-th syndrome using the Horner rule without parallelism, and includes an adder 11, an accumulator 12 and a multiplier 13. The adder 11 sums the input $r_j\alpha^0$, where $r_j$ is the coefficient of the jth term and $\alpha$ is a primitive element, with the product of the *i*th primitive element $\alpha^i$ with the result accumulated in the accumulator 11 received from the multiplier 13, and the accumulator accumulates successive results of the sum received from the adder 11. However, the Horner rule implementation is not efficient for SPolar architecture as-is, as the syndrome is updated on-the-fly and not in order. FIG. 1B shows hardware that calculates the i-th syndrome using the Horner rule with parallelism of p inputs. In particular, the hardware of FIG. 1B can process p inputs in parallel, where b(p-i) is the coefficient of the (p-i+1)th term, but the p inputs are received in order to work correctly.

**Option 2: General HW for syndrome $S_i$ from symbol $j$:**

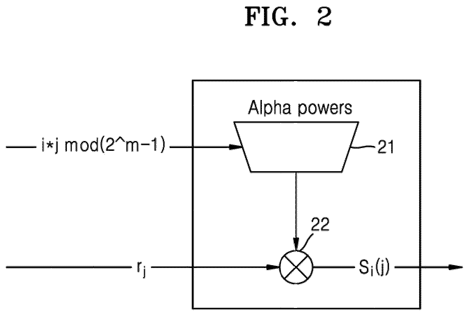

Another option for syndrome calculation is to calculate the contribution of each symbol, $r_j$, to the syndrome and accumulate it, as shown in FIG. 2. The figure illustrates the naive hardware solution for a syndrome calculation, when the word symbols are received out of order. The hardware calculates the *i*-th syndrome. The figures shows multiplexor 21, which outputs a power of the primitive element $\alpha$ selected by $(i\times j)\mod((2^m)-1)$ of the mth syndrome, and multiplier 22 that receives the *j*-th symbol, with its index ($j$), and the selected $\alpha$, and outputs the contribution of this symbol to the *i*-th syndrome. To get the total result of the *i*-th syndrome, the contribution of all symbols is accumulated (XORed).

A direct implementation may be configured with more hardware. This method uses a general Galois field (GF) multiplier per syndrome, while the Horner implementation uses a constant-multiplier, and option 2 is configured with a preliminary calculation of $i\times j \mod (2^m-1)$ per syndrome.

However, the second option has few advantages over Horner-rule hardware: When symbols arrive out of order, option two is easier and faster to use, and hardware (HW) parallelism for different syndromes $S_i$ is

possible. However, an embodiment may calculate about 70 RS syndromes for a word in the first column, and use fewer than 70 hardware "boxes", and just update the "i×j" result. Further, there is a latency, since the syndrome update calculation (per frame) takes 1 cycle.

**Generalized Concatenated Error Codes**

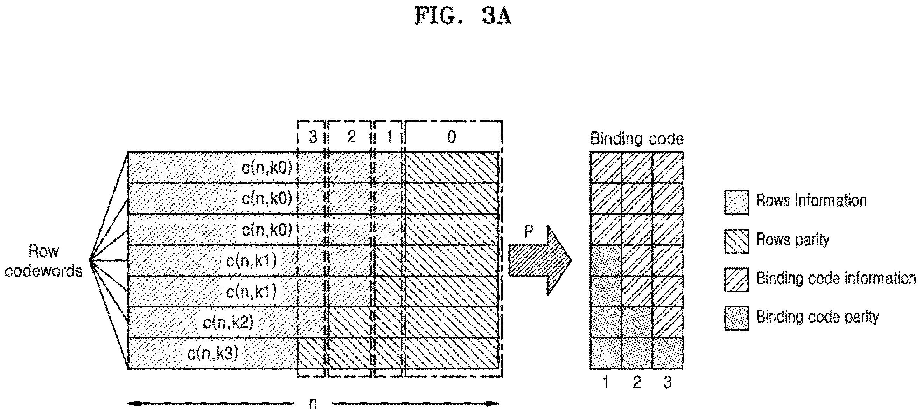

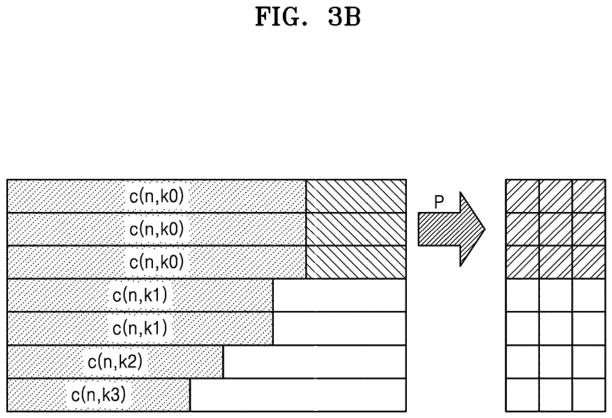

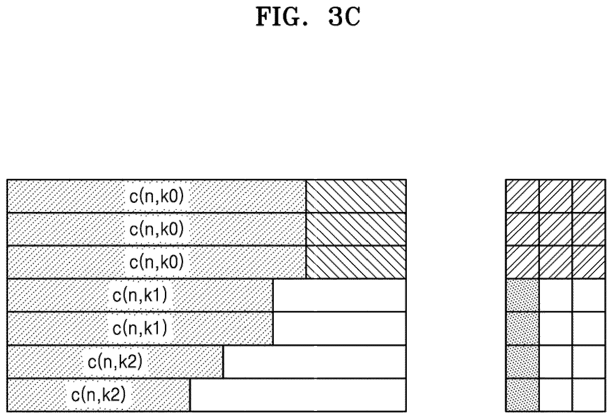

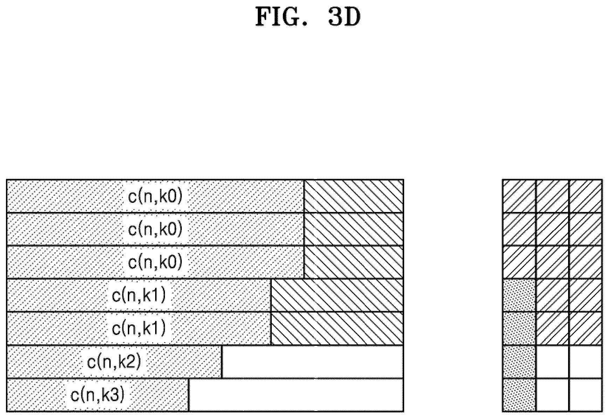

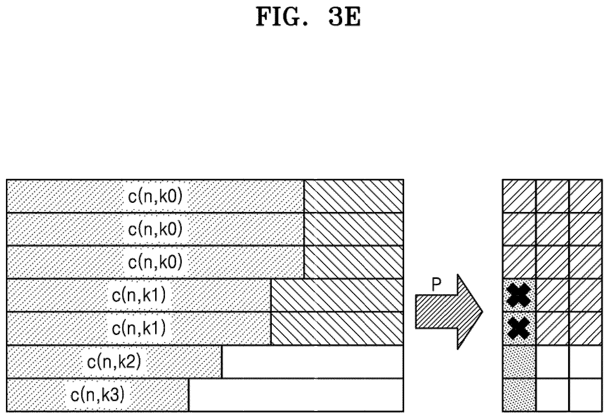

Generalized concatenated codes are two dimensional structures where rows of codewords are bonded together by a different code. In other words, the codewords meet together with a joint constraint. FIGs. 3A, 3B, 3C, 3D, and 3E illustrate decoding of generalized concatenated error correction code words, according to embodiments of the disclosure. An example is the SPolar code, in which the inner code is a Polar code, and the outer (binding) code is an RS code. The left side of FIG. 3A shows a block of generalized concatenated code words $c(n, k_i)$, where $n$ is the length of the code, and $k_i$ is the dimension of the code.

All rows are of the same length $n$ but different dimensions $k$. In the encoding process, the code words are grouped to S stages by their dimensions, so that each stage s, where $s = 1, ..., S-1,$ contains all words $c(n, k_s)$, where s refers to a specific stage, and $S$ is the number of stages. In FIGS. 3A-3E, S = 4. Note that RS columns are associated with the stage, but they are not part of the codeword itself. They only define the constraints on the parity. Stages 0, 1, 2 and 3, are indicated by numbered vertically oriented boxes in FIG. 3A, and the associated binding codes on the right side are similarly labeled. The encoder encodes each row with parity that will satisfy RS codeword. Each word is multiplied by some matrix P that produces a row of symbols in an auxiliary matrix, shown on the right side of FIG. 3A. The auxiliary matrix columns are codewords in the binding code. The number of columns is at least S - 1, and each column is associated to some stage and has the same number of information symbols as the number of rows in that stage.

After all rows of stage s are encoded, the encoder computes their P transform and obtains all the information symbols of the relevant columns in the auxiliary matrix. FIG. 3B shows the rows for stage s=0 and transformed into the auxiliary matrix on the right.

Referring to FIG. 3C, the encoders of stage s columns are activated and all the column symbols are computed. Referring to FIG. 3D, the next stage starts, and its rows are encoded. Referring to FIG. 3E, the P transform is activated on the recently encoded rows, but some of the right-hand side symbols were already determined. The symbols in the auxiliary matrix that are marked with an X are parities of the binding code and are also the results of the row's P transform. This conflict is resolved by adding affine constraints $Pc = d$ to the rows codes, where $d$ is determined by the auxiliary matrix.

Traditional methods of decoding GCCs decode all rows, and then calculate RS syndromes for the first column. However, it is time consuming to calculate the delta -syndromes, and storing them somewhere may also increase the overhead. It would be more efficient to calculate syndromes on-the-fly, and to have a greedy algorithm that, when enough rows are decoded, perform RS decoding and proceed to a higher stage of the decoding, without waiting for all rows to be decoded. This involves decoding the rows out of order. Note that Horner's method uses the locality property of polynomials, and multiplies the coefficient by the same power of $\alpha$ at each step. This calculation will not work for out-of-order $\alpha$'s.

## Iterative parallel hardware to handle single RSS column

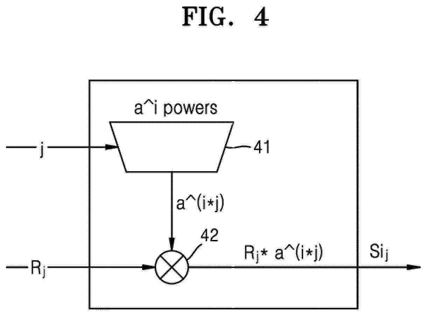

Embodiments of the disclosure use an iterative parallel hardware to handle single RSS column. In a first step, the general multiplier is eliminated by defining Si specific hardware. For a known syndrome, $S_i$, the contribution of the j-th frame will be $R_j \times \alpha^{ij}$, where $R_j$ is the j-th RS-word symbol. An exemplary hardware for specific syndrome $i$ is illustrated in FIG. 4, which shows multiplexor 41 and multiplier 42. Instead of calculating $i \times j$ and then getting $\alpha^{ij}$ from a multiplexor of $\alpha$ powers, the multiplexor 41 of $\alpha^i$ powers is used, selected by $j$ only, and the multiplier 42 outputs the product of the selected power of $\alpha$ and the j-th RS-word symbol $R_j$. Although this solution spares the multiplier of $i \times j$, it may be configured with a special multiplexor of $\alpha^i$ powers for each syndrome $i$, $i=1$, $2, \ldots, D$.

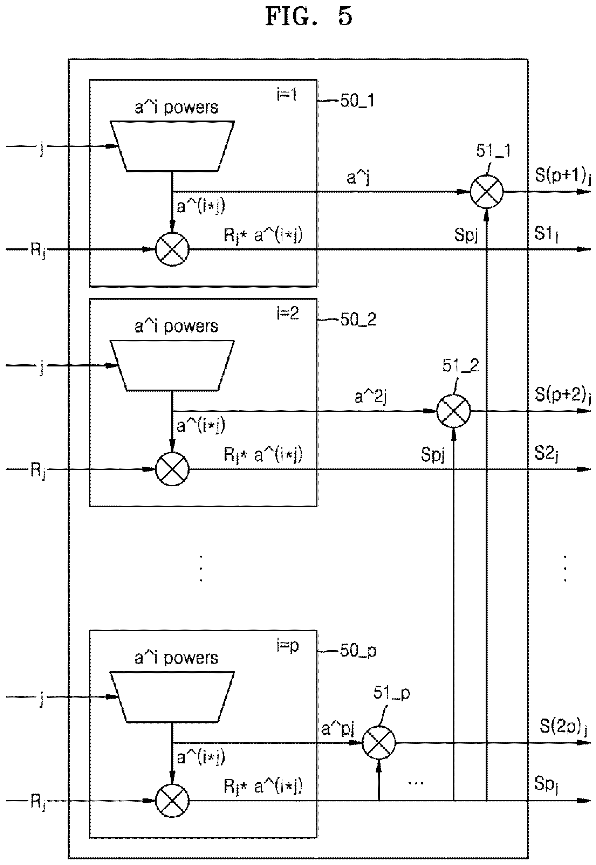

A next step involves an iterative calculation, illustrated in FIG. 5. An iterative calculation according to embodiments of the disclosure re-uses the basic HW shown in FIG. 4 in a few iterations to complete all syndrome updates by the symbol Rj. FIG. 5 shows basic hardware units 50_1, 50_2, ..., 50_p, where p is a positive integer. For convenience of illustration, the individual components of each basic hardware unit are not labeled. Each basic hardware unit shown in FIG. 5 is associated with an additional GF multiplier 51_1, 51_2, ..., 51_p, respectively. For example: to update 40 syndromes with the j-th symbol, instead of having 40 parallel hardware units, one can select parallelism, for example, p=5, and repeat the calculation $40/(5 \times 2) = 4$ times. For example, 5 instances of HW will output calculation for the first 5 syndromes (addition) $S_1$, $S_2$, ..., $S_5$. With the additional GF multiplier, another set of additions to syndromes $S_6$, ..., $S_{10}$ can be obtained. In the next cycle, with feedback of the last calculation $(S(2p)_i)$ to the $R_j$ input, instead of the original syndrome, another 5+5 syndromes $S_{11}$, ..., $S_{15}$, $S_{16}$, ..., $S_{20}$ are obtained.

Notice that for the ith instance of the hardware that calculates the ith RS syndrome (HW$_i$), there is an alpha power of $i \times j$, and taking the last syndrome $R_j \times \alpha^{pj}$ for some parallelism p, and multiplying it by alpha powers, a 2nd set of syndromes p+1... 2p is obtained. In the subsequent cycle(s), the last syndrome $(S_{2P})$ is multiplexed to R inputs, and the next 2P results are received.

In an alternative non-claimed example, note that the same solution can be obtained if $\alpha^{pj}$ is taken out of the last module, and multiplied by the calculated syndromes $S_1$ to $S_p$. For an SPolar implementation, both embodiments are substantially the same, although they may very slightly differ in area/power/timing, depending on other design parameters.

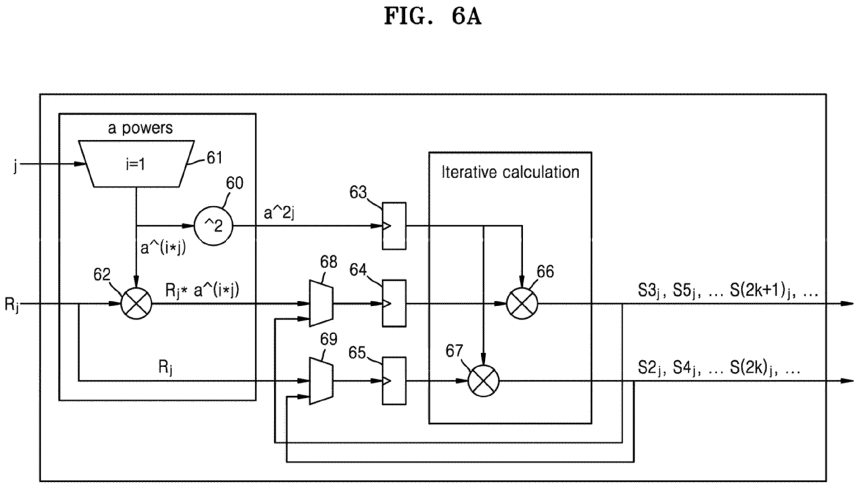

Embodiments provide further area optimizations. FIG. 6A shows a basic hardware unit with multiplexor 61, multiplier 62, and GF-square hardware unit 60, registers 63, 64, and 65, iterative multipliers 66 and 67, and pipeline multiplexors 68 and 69. Referring to FIG. 6A, for example, from the 2nd iteration on, $\alpha^{ij}$ can be sampled or kept stable in the registers 63, 64 and 65, and 2nd 2 sets (or more) can be implemented with only the 2 iterative multipliers 66 and 67. Since $\alpha^{ij}$ powers are actually common to all RS symbol (RSS) columns, if they are calculated once, the 2nd iteration hardware can be used for all calculations. This optimization obtains a$^{2j}$ from $\alpha^j$, using GF-square hardware unit 60 only, and thus achieve double throughput, without using a multiplier. GF-square hardware unit has a relatively small size, as it uses few XOR gates. In addition, it supports pipeline architecture, using the pipeline multiplexors 68 and 69, as it enables starting a new calculation when the previous one is still in the iterative calculation stage. Even powers of alpha, 2i, can be derived from $i$ powers with GF-square hardware unit 60, which has a relatively small size, estimated to be few XOR gates. For the first RSS column in an SPolar code, the results are provided as fast as possible, but the next columns have a slow calculation in the background.

Using an alternative embodiment described above, and sampling the results to registers before updating the RSS column, only $\alpha^{pj}$ should be kept, and 2-3 syndromes per cycle can be calculated in the background.

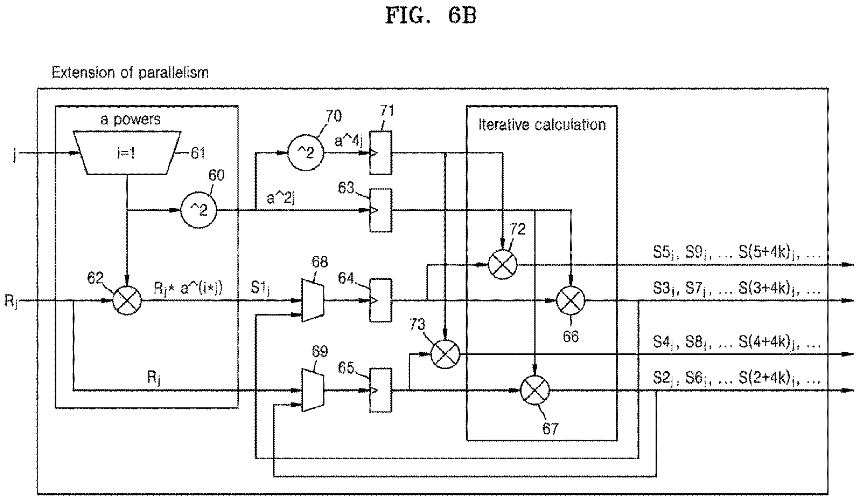

Another iterative unit of multiplying by $\alpha^{4j}$ can be added in parallel to $\alpha^{2j}$, shown in FIG. 6B, where the same reference numbers refer to the same components in FIG. 6A, with reduced or minimal timing cost of square calculation and area cost of 2 multipliers and square. FIG. 6B includes, in addition to the components of FIG. 6A, a GF-square hardware unit 70, register 71, and iterative multipliers 72 and 73, Notice that the alpha powers logic in the left HW module in FIG. 5 can also be shared between several RSS columns, based on receiving $\alpha^j$ and $\alpha^{2j}$. FIG. 6B shows that more calculations can be performed per second with reduced or minimal additional hardware, primarily an additional GF square hardware (minimal) and two more GF multipliers in the iterative hardware.

## Throughput (TP) And Area Tradeoff

The number of GF multipliers configured in the first and in the second phase, where the first phase includes the alpha powers and second phase is the iterative HW, depends on the expected TP. Planning the logic of RSS update should take into account the throughput configuration: the rate that updates are received, and the number of syndromes configured to calculate.

**Claims**

1. A hardware circuit for calculating syndromes in Reed-Solomon, RS, error correction codes, comprising:

   a plurality of $p$ multiplexors (41, 61), wherein $p$ is a positive integer, wherein each multiplexor (41, 61) is configured to:
   receive $\alpha^{\wedge}i$ powers that are selected by $j$, wherein $\alpha$ is a primitive point of a RS generator polynomial and $j$ is an index of an RS symbol, wherein $i$ and $j$ are positive integers, wherein $1 \leq i \leq p$, and outputs $\alpha^{\wedge}(i \times j)$; and
   a plurality of $p$ first multipliers (42, 62), wherein each first multiplier (42, 62) is associated with a multiplexor (41, 61) of the plurality of p multiplexors (41, 61) and is configured to:

      receive $\alpha^{\wedge}(i \times j)$ from the associated multiplexor (41, 61),
      multiply the $\alpha^{\wedge}(i \times j)$ by a $j$th RS-word symbol $R_j$, and
      output $R_j \times \alpha^{\wedge}(i \times j)$,

   wherein the hardware circuit is configured to calculate and output $p$ syndromes as $p$ products of the form $R_f \times \alpha^{\wedge}(i \times j)$, wherein $1 \leq i \leq p$, the hardware circuit further comprising:
   a plurality of $p$ second multipliers (51_1 to 51_p, 67), wherein each second multiplier (51_1 to 51_p, 67) is associated with a multiplexor of the plurality of p multiplexors (41, 61), and is configured to:

      receive $\alpha^{\wedge}(i \times j)$ from the associated multiplexor (41, 61) and $R_j \times \alpha^{\wedge}(p \times j)$ from a $p$th first multiplier of the plurality of first multipliers (42, 62), and
      multiply the $R_j \times \alpha^{\wedge}(p \times j)$ by the $\alpha^{\wedge}(i \times j)$,
      wherein the hardware circuit is further configured to calculate and output $p$ further syndromes as $p$ products of the form $R_j \times \alpha^{\wedge}((i+p) \times j)$, wherein $1 \leq i \leq p$.

2. The hardware circuit of claim 1, wherein for $n$ syndromes, wherein $n = 2 \times p \times m$, wherein $n$ and $m$ are positive integers, the circuit is configured to repeat calculating and outputting a next $2 \times p$ products $m$ times, wherein the $j$th RS-word symbol $R_j$ for a $k$th iteration is replaced by $R_j \times \alpha^{\wedge}(2pj)$ from a (k-1)th iteration, wherein $1 \leq k \leq m$.

3. The hardware circuit of claim 1, further comprising:

   a first GF-square hardware unit (60) connected to an output of each multiplexor (41, 61), wherein the first GF-square hardware unit (60) squares the $\alpha^{\wedge}(i \times j)$ received from the connected multiplexor (41, 61);
   a first register (63), a second register (64), and a third register (65), wherein the first register (63) is configured to store a result $\alpha^{\wedge}2(i \times j)$ received from the first GF-square hardware unit (60), the second register (64) is configured to store a result $R_j \times \alpha^{\wedge}(i \times j)$ received from a first multiplier (62) associated with the connected multiplexor (41, 61), and the third register (65) is configured to store the $j$th RS-word symbol $R_j$;
   a first iterative multiplier (66) configured to calculate a first product of the result stored in the first register (63) and the result $R_j \times \alpha^{\wedge}(i \times j)$ stored in the second register (64), and output the first product; and
   a second iterative multiplier (67) configured to calculate a second product of the result stored in the first register (63) and the $j$th RS-word symbol $R_j$, and output the second product,
   wherein the result $\alpha^{\wedge}2(i \times j)$ stored in the first register (63) is kept stable for all subsequent calculations of the syndrome.

4. The hardware circuit of claim 3, further comprising:

   a first pipeline multiplexor (68) disposed between the first multiplier (62) of each multiplexor (41, 61) and the second register (64); and
   a second pipeline multiplexor (69) disposed between an input line for the $j$th RS-word symbol $R_j$ and the third register (65),
   wherein the first pipeline multiplexor (68) is configured to receive the first product from the first iterative multiplier (66), the second pipeline multiplexor (69) is configured to receive the second product from the second iterative multiplier (67), and
   where each of the first and second pipeline multiplexor (69) is respectively configured to select the first product and the second product for a new calculation of $R_j \times \alpha^{\wedge}(i \times j)$ and $R_j \times \alpha^{\wedge}((i+p) \times j)$ while a previous calculation of $R_j \times \alpha^{\wedge}(i \times j)$ and $R_j \times \alpha^{\wedge}((i+p) \times j)$ is still in progress.

5. The hardware circuit of claim 3 or 4, further comprising:

   a second GF-square hardware unit (70) connected to an output of each first GF-square hardware unit (60), wherein the second GF-square hardware unit (70) is configured to square the $\alpha^{\wedge}(2j)$ received from the connected first GF-square hardware unit (60);
a third iterative multiplier (72) configured to calculate a third product of a result $\alpha^{\wedge}(4j)$ received from the second GF-square hardware unit (70) and the result $R_j \times \alpha^{\wedge}(i \times j)$ stored in the second register (64), and output the third product, and a fourth iterative multiplier (73) configured to calculate a fourth product of the result $\alpha^{\wedge}(4j)$ received from the second GF-square hardware unit (70) and the $j$th RS-word symbol $R_j$ stored in the third register (65), and output the second product.

6. The hardware circuit of claim 5, further comprising: a fourth register (71) disposed between the second GF-square hardware unit (70) and the third iterative multiplier (72), wherein the fourth register (71) is configured to store the result $\alpha^{\wedge}(4j)$ received from the second GF-square hardware unit (70).

**Patentansprüche**

1. Hardwareschaltung zum Berechnen von Syndromen in Reed-Solomon-, RS-, Fehlerkorrekturcodes, aufweisend:
eine Vielzahl von $p$ Multiplexern (41, 61), wobei $p$ eine positive Ganzzahl ist, wobei jeder Multiplexer (41, 61) konfiguriert zum:

Empfangen von $\alpha^{\wedge}i$-Potenzen, die durch $j$ ausgewählt werden, wobei $\alpha$ ein primitiver Punkt eines RS-Generatorpolynoms ist und $j$ ein Index eines RS-Symbols ist, wobei $i$ und $j$ positive Ganzzahlen sind, wobei $1 \le i \le$ p ist, und $\alpha^{\wedge}(i \times j)$ ausgibt; und
eine Vielzahl von $p$ ersten Multiplikatoren (42, 62), wobei jeder erste Multiplikator (42, 62) einem Multiplexer (41, 61) aus der Vielzahl von p Multiplexern (41, 61) zugeordnet ist und so konfiguriert ist zum:

Empfangen von $\alpha^{\wedge}(i \times j)$ von dem zugeordneten Multiplexer (41, 61),
Multiplizieren des $\alpha^{\wedge}(i \times j)$ mit einem $j$-ten RS-Wortsymbol $R_j$ und
Ausgeben *von* $R_j \times \alpha^{\wedge}(i \times j)$,
wobei die Hardwareschaltung konfiguriert ist zum Berechnen und Ausgeben von $p$ Syndromen als $p$ Produkte der Form $R_j \times \alpha^{\wedge}(i \times j)$,
wobei $1 \le i \le$ p,
wobei die Hardwareschaltung ferner aufweist:

eine Vielzahl von $p$ zweiten Multiplikatoren (51_1 bis 51_p, 67),
wobei jeder zweite Multiplikator (51_1 bis 51_p, 67) einem Multiplexer von der Vielzahl von einem p Multiplexern (41, 61) zugeordnet ist und konfiguriert ist zum:

Empfangen von $\alpha^{\wedge}(i \times j)$ von dem zugeordneten Multiplexer (41, 61) und $R_j \times \alpha^{\wedge}(p \times j)$ von einem $p$-ten ersten Multiplikator von der Vielzahl von ersten Multiplikatoren (42, 62), und Multiplizieren von $R_j \times \alpha^{\wedge}(p \times j)$ mit $\alpha^{\wedge}(i \times j)$,
wobei die Hardwareschaltung ferner so konfiguriert ist, dass sie $p$ weitere Syndrome als $p$ Produkte der Form $R_j \times \alpha^{\wedge}((i+\rho) \times j)$ berechnet und ausgibt, wobei $1 \le i \le$ p.

2. Hardwareschaltung nach Anspruch 1, wobei für $n$ Syndrome, wobei $n = 2 \times p \times m$, wobei $n$ und $m$ positive Ganzzahlen sind, die Schaltung so konfiguriert ist, dass sie die Berechnung und Ausgabe von nächsten $2 \times p$ Produkte $m$-mal wiederholt, wobei das $j$-te RS-Wortsymbol $R_j$ für eine $k$-te Iteration durch $R_j \times \alpha^{\wedge}(2p_j)$ aus einer (k-1)-ten Iteration ersetzt wird, wobei $1 \le$ k $\le m$.

3. Hardware-Schaltung nach Anspruch 1, ferner aufweisend:

eine erste GF-Quadrat-Hardwareeinheit (60), die mit einem Ausgang jedes Multiplexers (41, 61) verbunden ist, wobei die erste GF-Quadrat-Hardwareeinheit (60) das von dem verbundenen Multiplexer (41, 61) empfangene $\alpha^{\wedge}(i \times_j)$ quadriert;
ein erstes Register (63), ein zweites Register (64) und ein drittes Register (65), wobei das erste Register (63) so konfiguriert ist, dass es ein von der ersten GF-Quadrat-Hardwareeinheit (60) empfangenes Ergebnis $\alpha^{\wedge}2(i \times j)$ speichert, das zweite Register (64) so konfiguriert ist, dass es ein Ergebnis $R_j \times \alpha^{\wedge}(i \times j)$ speichert, das von einem ersten Multiplikator (62) empfangen wird, der dem verbundenen Multiplexer (41, 61) zugeordnet ist, und das dritte Register (65) so konfiguriert ist, dass es das $j$-te RS-Wortsymbol $R_j$ speichert;
einen ersten iterativen Multiplikator (66), der so konfiguriert ist, dass er ein erstes Produkt aus dem in dem ersten Register (63) gespeicherten Ergebnis und dem in dem zweiten Register (64) gespeicherten Ergebnis $R_j \times \alpha^{\wedge}(i \times j)$ berechnet und das erste Produkt ausgibt; und
einen zweiten iterativen Multiplikator (67), der so konfiguriert ist, dass er ein zweites Produkt aus dem in dem im ersten Register (63) gespeicherten Ergebnis und dem j-ten RS-Wortsymbols $R_j$

berechnet und das zweite Produkt ausgibt, wobei das in dem ersten Register (63) gespeicherte Ergebnis $\alpha{\char`\^}2(i{\times}j)$ für alle nachfolgenden Berechnungen des Syndroms stabil gehalten wird.

4. Hardwareschaltung nach Anspruch 3, ferner aufweisend:

einen ersten Pipeline-Multiplexer (68), der zwischen dem ersten Multiplikator (62) jedes Multiplexers (41, 61) und dem zweiten Register (64) angeordnet ist; und
einen zweiten Pipeline-Multiplexer (69), der zwischen einer Eingangsleitung für das j-te RS-Wortsymbol $R_j$ und dem dritten Register (65) angeordnet ist,
wobei der erste Pipeline-Multiplexer (68) so konfiguriert ist, dass er das erste Produkt von dem ersten iterativen Multiplikator (66) empfängt, der zweite Pipeline-Multiplexer (69) so konfiguriert ist, dass er das zweite Produkt von dem zweiten iterativen Multiplikator (67) empfängt, und
wobei jeder von dem ersten und zweiten Pipeline-Multiplexer (69) jeweils so konfiguriert ist, dass er das erste Produkt und das zweite Produkt für eine neue Berechnung von $R_j{\times}\alpha{\char`\^}(ixj)$ und $R_j{\times}\alpha{\char`\^}((i{+}p){\times}j)$ auswählt, während eine vorherige Berechnung von $R_j{\times}\alpha{\char`\^}(i{\times}j)$ und $R_j{\times}\alpha{\char`\^}((i{+}p){\times}j)$ noch im Gange ist.

5. Hardware-Schaltung nach Anspruch 3 oder 4, ferner aufweisend:

eine zweite GF-Quadrat-Hardwareeinheit (70), die mit einem Ausgang jeder ersten GF-Quadrat-Hardwareeinheit (60) verbunden ist, wobei die zweite GF-Quadrat-Hardwareeinheit (70) so konfiguriert ist, dass sie das von der verbundenen ersten GF-Quadrat-Hardwareeinheit (60) empfangene $\alpha{\char`\^}(2_j)$ quadriert;
einen dritten iterativen Multiplikator (72), der so konfiguriert ist, dass er ein drittes Produkt aus einem von der zweiten GF-Quadrat-Hardwareeinheit (70) empfangenen Ergebnis $\alpha{\char`\^}(4_j)$ und dem in dem zweiten Register (64) gespeicherten Ergebnis $R_j{\times}\alpha{\char`\^}(i{\times}j)$ berechnet und das dritte Produkt ausgibt, und
einen vierten iterativen Multiplikator (73), der so konfiguriert ist, dass er ein viertes Produkt aus dem von der zweiten GF-Quadrat-Hardwareeinheit (70) empfangenen Ergebnis $\alpha{\char`\^}(4_j)$ und dem in dem dritten Register (65) gespeicherten j-ten RS-Wortsymbol $R_j$ berechnet und das zweite Produkt ausgibt.

6. Hardware-Schaltung nach Anspruch 5, ferner aufweisend:

weisend:

ein viertes Register (71), das zwischen der zweiten GF-Quadrat-Hardwareeinheit (70) und dem dritten iterativen Multiplikator (72) angeordnet ist, wobei das vierte Register (71) so konfiguriert ist, dass es das von der zweiten GF-Quadrat-Hardwareeinheit (70) empfangene Ergebnis $\alpha{\char`\^}(4_j)$ speichert.

**Revendications**

1. Circuit matériel pour calculer des syndromes dans des codes de correction d'erreurs de Reed-Solomon, RS, comprenant :
une pluralité de $p$ multiplexeurs (41, 61), $p$ étant un entier positif, chaque multiplexeur (41, 61) étant configuré pour :

recevoir des puissances $\alpha{\char`\^}i$ sélectionnées par $j$, $\alpha$ étant un élément primitif d'un polynôme générateur RS et $j$ étant un indice d'un symbole RS, $i$ et $j$ étant des entiers positifs, $1 \leq i \leq p$, et délivrer $\alpha{\char`\^}(i{\times}j)$ ; et
une pluralité de $p$ premiers multiplicateurs (42, 62), chaque premier multiplicateur (42, 62) étant associé à un multiplexeur (41, 61) de la pluralité de $p$ multiplexeurs (41, 61) et étant configuré pour :

recevoir $\alpha{\char`\^}(i{\times}j)$ du multiplexeur associé (41, 61),
multiplier $\alpha{\char`\^}(i{\times}j)$ par un j-ème symbole de mot RS $Rj$, et
délivrer $Rj{\times}\alpha{\char`\^}(i{\times}j)$,

le circuit matériel étant configuré pour calculer et délivrer $p$ syndromes sous forme de $p$ produits de la forme $Rj{\times}\alpha{\char`\^}(i{\times}j)$, $1 \leq i \leq p$,
le circuit matériel comprenant en outre :
une pluralité de $p$ deuxièmes multiplicateurs (51_1 à 51_p, 67), chaque deuxième multiplicateur (51_1 à 51_p, 67) étant associé à un multiplexeur de la pluralité de $p$ multiplexeurs (41, 61) et étant configuré pour :

recevoir $\alpha{\char`\^}(i{\times}j)$ du multiplexeur associé (41, 61) et $Rj{\times}\alpha{\char`\^}(p{\times}j)$ d'un p-ème premier multiplicateur de la pluralité de premiers multiplicateurs (42, 62), et
multiplier $Rj{\times}\alpha{\char`\^}(p{\times}j)$ par $\alpha{\char`\^}(i{\times}j)$,
le circuit matériel étant en outre configuré pour calculer et délivrer $p$ autres syndromes sous forme de $p$ produits de la forme $Rj{\times}\alpha{\char`\^}((i{+}p){\times}j)$, $1 \leq i \leq p$.

2. Circuit matériel selon la revendication 1, dans lequel, pour $n$ syndromes, $n = 2{\times}p{\times}m$, $n$ et $m$ étant des entiers positifs, le circuit est configuré pour répéter $m$

fois le calcul et la délivrance de $2 \times p$ produits suivants, le *j*-ème symbole de mot RS $R_j$ pour une *k*-ème itération étant remplacé par $Rj \times \alpha^{\wedge}(2pj)$ provenant d'une (k-1)-ème itération, $1 \leq k \leq m$.

**3.** Circuit matériel selon la revendication 1, comprenant en outre :

une première unité matérielle de mise au carré GF (60) connectée à une sortie de chaque multiplexeur (41, 61), la première unité matérielle de mise au carré GF (60) mettant au carré le $\alpha^{\wedge}(i \times j)$ reçu du multiplexeur connecté (41, 61) ;

un premier registre (63), un deuxième registre (64) et un troisième registre (65), le premier registre (63) étant configuré pour stocker un résultat $\alpha^{\wedge}2(i \times j)$ reçu de la première unité matérielle de mise au carré GF (60), le deuxième registre (64) étant configuré pour stocker un résultat $Rj \times \alpha^{\wedge}(i \times j)$ reçu d'un premier multiplicateur (62) associé au multiplexeur connecté (41, 61), et le troisième registre (65) étant configuré pour stocker le j-ème symbole de mot RS $Rj$ ;

un premier multiplicateur itératif (66) configuré pour calculer un premier produit du résultat stocké dans le premier registre (63) et du résultat $Rj \times \alpha^{\wedge}(i \times j)$ stocké dans le deuxième registre (64), et délivrer le premier produit ; et

un deuxième multiplicateur itératif (67) configuré pour calculer un deuxième produit du résultat stocké dans le premier registre (63) et du -ème symbole de mot RS $Rj$, et délivrer le deuxième produit,

le résultat $\alpha^{\wedge}2(i \times j)$ stocké dans le premier registre (63) étant maintenu stable pour tous les calculs ultérieurs du syndrome.

**4.** Circuit matériel selon la revendication 3, comprenant en outre :

un premier multiplexeur en pipeline (68) disposé entre le premier multiplicateur (62) de chaque multiplexeur (41, 61) et le deuxième registre (64) ; et

un deuxième multiplexeur en pipeline (69) disposé entre une ligne d'entrée pour le *j*-ème symbole de mot RS $Rj$ et le troisième registre (65),

le premier multiplexeur en pipeline (68) étant configuré pour recevoir le premier produit du premier multiplicateur itératif (66), le deuxième multiplexeur en pipeline (69) étant configuré pour recevoir le deuxième produit du deuxième multiplicateur itératif (67), et

chacun des premier et deuxième multiplexeurs en pipeline (69) étant respectivement configuré pour sélectionner le premier produit et le deuxième produit pour un nouveau calcul de $Rj \times \alpha^{\wedge}(i \times j)$ et de $Rj \times \alpha^{\wedge}((i+p) \times j)$ tandis qu'un calcul précédent de $Rj \times \alpha^{\wedge}(i \times j)$ et de $Rj \times \alpha^{\wedge}((i+p) \times j)$ est encore en cours.

**5.** Circuit matériel selon la revendication 3 ou 4, comprenant en outre :

une deuxième unité matérielle de mise au carré GF (70) connectée à une sortie de chaque première unité matérielle de mise au carré GF (60), la deuxième unité matérielle de mise au carré GF (70) étant configurée pour mettre au carré le $\alpha^{\wedge}(2j)$ reçu de la première unité matérielle de mise au carré GF (60) connectée ;

un troisième multiplicateur itératif (72) configuré pour calculer un troisième produit d'un résultat $\alpha^{\wedge}(4j)$ reçu de la deuxième unité matérielle de mise au carré GF (70) et du résultat $Rj \times \alpha^{\wedge}(i \times j)$ stocké dans le deuxième registre (64), et délivrer le troisième produit, et

un quatrième multiplicateur itératif (73) configuré pour calculer un quatrième produit du résultat $\alpha^{\wedge}(4j)$ reçu de la deuxième unité matérielle de mise au carré GF (70) et du j-ème symbole de mot RS $Rj$ stocké dans le troisième registre (65), et délivrer le deuxième produit.

**6.** Circuit matériel selon la revendication 5, comprenant en outre :
un quatrième registre (71) disposé entre la deuxième unité matérielle de mise au carré GF (70) et le troisième multiplicateur itératif (72), le quatrième registre (71) étant configuré pour stocker le résultat $\alpha^{\wedge}(4j)$ reçu de la deuxième unité matérielle de mise au carré GF (70).

FIG. 1A

FIG. 1B

# FIG. 2

FIG. 3A

# FIG. 3B

# FIG. 3C

| c(n,k0) |
| c(n,k0) |
| c(n,k0) |
| c(n,k1) |
| c(n,k1) |
| c(n,k2) |
| c(n,k2) |

FIG. 3D

FIG. 3E

# FIG. 4

a^i powers

j ——→ [41]

a^(i*j)

[42]

R_j ——→ ⊗ —— R_j* a^(i*j) —— Si_j ——→

# FIG. 5

**FIG. 6A**

FIG. 6B

EP 4 576 586 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20180152203 A1

- US 11689216 B1

**Non-patent literature cited in the description**

- Area-Efficient Parallel Syndrome Generators for Linear Block Codes. **CHO JUNHO et al.** Journal of Signal Processing Systems. Springer, 20 July 2023, vol. 77